# EUROPEAN PATENT APPLICATION

(11) **EP 2 543 752 A1**
(43) Date of publication of application: **09.01.2013**
(21) Application number: 11750807.7
(22) Date of filing: 04.03.2011
(51) Int. Cl.: C30B 29/20, B23K 26/40, C30B 33/02, H01L 21/02, H01L 21/20, H01L 21/268, H01L 21/324, H01L 33/00

(54) **INTERNAL REFORMING SUBSTRATE FOR EPITAXIAL GROWTH, INTERNAL REFORMING SUBSTRATE WITH MULTILAYER FILM, SEMICONDUCTOR DEVICE, BULK SEMICONDUCTOR SUBSTRATE, AND PRODUCTION METHODS THEREFOR**

(30) Priority: 05.03.2010 JP 2010049857
(71) Applicant: Namiki Seimitsu Houseki kabushikikaisha, Adachi-ku Tokyo 123-8511 (JP); Disco Corporation, Tokyo 143-8580 (JP)
(72) Inventor: AIDA, Hideo, Tokyo 123-8511 (JP); AOTA, Natsuko, Tokyo 123-8511 (JP); HOSHINO, Hitoshi, Tokyo 143-8580 (JP); FURUTA, Kenji, Tokyo 143-8580 (JP); HAMAMOTO, Tomosaburo, Tokyo 143-8580 (JP); HONJO, Keiji, Tokyo 143-8580 (JP)
(74) Representative: Skone James, Robert Edmund
(86) International application number: PCT/JP2011/055055
(87) International publication number: WO 2011/108698

(57) **Abstract**

Provided are an internally reformed substrate for epitaxial growth having an arbitrary warpage shape and/or an arbitrary warpage amount, an internally reformed substrate with a multilayer film using the internally reformed substrate for epitaxial growth, a semiconductor device, a bulk semiconductor substrate, and manufacturing methods therefor. The internally reformed substrate for epitaxial growth includes: a single crystal substrate; and a heat-denatured layer formed in an internal portion of the single crystal substrate by laser irradiation to the single crystal substrate.

## Description

### Technical Field

The present invention relates to an internally reformed substrate for epitaxial growth, an internally reformed substrate with a multilayer film, a semiconductor device, a bulk semiconductor substrate, and manufacturing methods therefor.

### Background Art

A nitride semiconductor represented by gallium nitride (GaN) has a wide band gap and is capable of blue light emission, and hence the nitride semiconductor is widely used in a light emitting diode (LED), a semiconductor laser (LD), and the like. In recent years, an effort to further increase the luminous efficiency and luminance has been actively made.

The structure of a typical nitride semiconductor light emitting element has a double hetero structure in which, on a sapphire substrate, a buffer layer made of GaN, an n-type contact layer made of n-type GaN, an n-type cladding layer made of n-type AlGaN, an active layer made of n-type InGaN, a p-type cladding layer made of p-type AlGaN, and a p-type contact layer made of p-type GaN are stacked in this order. The active layer contains In of a single quantumwell (SQW) structure having only a well layer made of InxGa1-xN (0≤X≤1) or a multi-quantum well (MQW) structure having the well layer made of InxGa1-xN (0≤X≤1) and a barrier layer made of InyGa1-yN (0≤y≤1, y<x) (see Patent Literature 1).

It is known that, when the above-mentioned multilayer film is formed on the sapphire substrate, warpage occurs in the sapphire substrate after the film formation due to differences in thermal expansion coefficient and lattice constant between the multilayer film and sapphire. For example, Non Patent Literature 1 discloses the result of a study in which an AIN buffer layer and a GaN layer are epitaxially grown on a sapphire substrate to determine how a thermal stress generated by the film formation is relieved depending on the film thickness of the GaN layer. Non Patent Literature 1 reveals that the warpage of the substrate is increased as the film thickness is increased, and interference defects, microcracks, dislocation, or macrocracks occur correspondingly to the increase, and accordingly the stress is relieved.

In addition, FIG. 4 of Non Patent Literature 2 discloses an analysis method in which the warpage of a substrate occurring through the step of epitaxially growing a GaN-based LED structure on a sapphire substrate is observed in situ. According to this method, it is revealed that, in a series of film formation steps, the curvature of the sapphire substrate significantly changes due to changes in film forming substance, film formation temperature, and film thickness. Further, it is revealed that, by adopting the film formation steps that allow the curvature of the sapphire substrate to become substantially 0 at the stage of the growth of the InGaN layer as the active layer, the emission wavelength in the surface of the substrate is uniformed.

As has been described above, it is known that the warpage of the sapphire substrate significantly changes through a series of film formation steps, and the quality of the nitride semiconductor film and the uniformity of the emission wavelength are thereby affected. Note that, in reality, the warpage shape and the warpage amount of the sapphire substrate are often set so that the substrate curvature becomes substantially 0 in the InGaN-based active layer by utilizing a difference in thermal expansion coefficient from that of the substrate. With the background described above, in order to control the shape and the warpage amount of the sapphire substrate, various polishing technologies are studied (see Patent Literature 2 and the like).

On the other hand, a technology is known in which, when a light emitting element obtained by stacking a nitride semiconductor on a sapphire substrate is divided, a pulsed laser is concentrated onto the internal portion of the sapphire substrate having a thickness of about 80 to 90 µm to form an affected region corresponding to a line for division of the light emitting element (Patent Literature 3). The technology disclosed in Patent Literature 3 is a method of processing the sapphire substrate capable of suppressing a reduction in the luminance of the light emitting element even when the substrate is divided into the individual light emitting elements by applying a laser beam to the sapphire substrate, and an object of the technology is the division of the light emitting element.

### Citation List

### Patent Literature

[PTL 1] JP 3250438 B
[PTL 2] JP 2006-347776 A
[PTL 3] JP 2008-6492 A
Non Patent Literature

[NPL1] Jpn. J. Appl. Phys. Vol. 32, (1993), pp. 1528-1533 [NPL 2] J. Cryst. Growth. Vol. 272, Issues 1-4, (2004), pp. 94-99

### Summary of Invention

### Technical Problems

As has been described above, the warpage of the single crystal substrate such as the sapphire substrate significantly changes through the series of film formation steps of obtaining the structure of the gallium nitride-based light emitting diode. With this, the quality of the nitride semiconductor layer and the uniformity of the emission wavelength are deteriorated, which leads to varied quality and reduced yield of the light emitting diode.

To cope with this problem, in the conventional method, the warpage shape and the warpage amount of the sapphire substrate are set so that the curvature of the substrate at the stage of the growth of the InGaN-based active layer becomes substantially 0. That is, in this method, an amount corresponding to the warpage amount occurring at the stage of the growth of the InGaN-based active layer is given to the sapphire substrate in advance so that the warpage amount is canceled out. With this, it is possible to suppress variations in emission wavelength to a certain extent. However, it is not possible to solve the problem of the warpage of the substrate occurring in the film formation steps of layers other than the InGaN-based active layer.

In particular, the significant warpage of the sapphire substrate at the stage of the growth of the n-GaN layer or when the substrate is cooled down after the film formation has led to problems such as reductions in film quality and uniformity of the film quality, variations in process precision in back grinding of the substrate, and variations in exposure resulting from defocusing in photolithography. These problems significantly affect the yield of a device such as the light emitting diode, and hence it has been necessary to suppress the warpage of the substrate and its change amount through the entire film formation steps so as to reduce the warpage behavior of the substrate itself. However, such a sapphire substrate has not been present conventionally.

In addition, when the diameter of the sapphire substrate is increased, there is a problem that it becomes difficult to precisely control the warpage shape and the warpage amount by polishing. It is known that warpage occurs in the polished sapphire substrate usually due to a remaining process strain or a difference in the surface roughness of finishing between upper and lower surfaces. For example, in the substrate with one surface polished, a difference in surface roughness between the upper and lower surfaces is a main cause of the warpage, while in the substrate with both surfaces polished, in addition to a slight difference in surface roughness between the upper and lower surfaces, slight variations in the surface roughness in the surface of the substrate are the cause of the warpage.

In particular, in a large-diameter substrate, there has been a problem related to technical limitations that it is technically difficult to uniform the surface roughness in the surface of the substrate, and it is not possible to precisely control, only by the polishing, the warpage shape and the warpage amount to achieve the desired warpage shape and the desired warpage amount.

In addition, there has been a problem that, in order to obtain a bulk nitride semiconductor substrate, when a thick film of the nitride semiconductor is to be epitaxially grown on the sapphire substrate to a free-standing thickness, the sapphire substrate is significantly warped due to a difference in thermal expansion coefficient between sapphire and the nitride semiconductor, and therefore the warpage amount is increased by a further increase in film thickness. Consequently, as the result, a crack occurs during or after the film formation so that it has been virtually impossible to obtain the free-standing bulk nitride semiconductor substrate.

As means for solving the above-mentionedproblems, there have been proposed, for example, an epitaxial lateral over growth (ELOG) method, a dislocation elimination of inverted-pyramidal pits (DEEP) method, and a void-assisted separation (VAS) method. However, each of those methods disadvantageously complicates the steps.

The present invention has been made in view of the above-mentioned circumstances, and therefore has an object to provide an internally reformed substrate for epitaxial growth having an arbitrary warpage shape and/or an arbitrary warpage amount, an internally reformed substrate with a multilayer film using the internally reformed substrate for epitaxial growth, a semiconductor device, a bulk semiconductor substrate, and manufacturing methods therefor.

### Solution to Problems

The above-mentioned object is attained by the present invention as follows.
Specifically, according to the present invention, there is provided an internally reformed substrate for epitaxial growth, including: a single crystal substrate; and a heat-denatured layer formed in an internal portion of the single crystal substrate by laser irradiation to the single crystal substrate.

In an internally reformed substrate for epitaxial growth according to an embodiment of the present invention, the laser irradiation is preferably performed so as to satisfy at least one of irradiation conditions A and B described below.

### <Irradiation Condition A>

- laser wavelength: 200 nm to 400 nm
- pulse width: order of nanoseconds

### <Irradiation Condition B>

• laser wavelength: 400 nm to 5,000 nm
• pulse width: order of femtoseconds to order of picoseconds

In an internally reformed substrate for epitaxial growth according to another embodiment of the present invention, when a relative position of the heat-denatured layer in a thickness direction of the single crystal substrate is assumed to be 0% at one surface serving as a film formation surface and 100% at a surface opposite to the film formation surface, the heat-denatured layer is preferably provided in a range of 3% or more and 95% or less in the thickness direction of the single crystal substrate.

In an internally reformed substrate for epitaxial growth according to still another embodiment of the present invention, in a planar direction of the single crystal substrate, the heat-denatured layer is preferably provided to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

In an internally reformed substrate for epitaxial growth according to still another embodiment of the present invention, the shape in which the plurality of polygons identical in shape and size are regularly disposed is preferably a lattice shape.

In an internally reformed substrate for epitaxial growth according to still another embodiment of the present invention, the lattice shape is preferably formed of a pattern in which a pitch between lines constituting the pattern is in a range of 50 µm or more and 2,000 µm or less.

In an internally reformed substrate for epitaxial growth according to still another embodiment of the present invention, the single crystal substrate is preferably made of at least one material selected from sapphire, a nitride semiconductor, Si, GaAs, crystal, and SiC.

In an internally reformed substrate for epitaxial growth according to still another embodiment of the present invention, the single crystal substrate before the heat-denatured layer is formed preferably has a shape in which the film formation surface is a concave surface, and the concave surface preferably has a curvature of more than 0 km⁻¹ and 160 km⁻¹ or less.

In an internally reformed substrate for epitaxial growth according to still another embodiment of the present invention, the single crystal substrate before the heat-denatured layer is formed preferably has a shape in which the film formation surface is a concave surface, and the concave surface preferably has a curvature of more than 40 km⁻¹ and 150 km⁻¹ or less.

In an internally reformed substrate for epitaxial growth according to still another embodiment of the present invention, the single crystal substrate before the heat-denatured layer is formed preferably has a shape in which the film formation surface is a concave surface, and the concave surface preferably has a curvature of more than 85 km⁻¹ and 150 km⁻¹ or less.

In an internally reformed substrate for epitaxial growth according to still another embodiment of the present invention, the single crystal substrate preferably has a diameter of 50 mm or more and 300 mm or less.

In an internally reformed substrate for epitaxial growth according to still another embodiment of the present invention, the single crystal substrate preferably has a thickness of 0.05 mm or more and 5.0 mm or less.

In an internally reformed substrate for epitaxial growth according to still another embodiment of the present invention, the surface serving as the film formation surface of the single crystal substrate is preferably a polished surface, and the laser irradiation to the single crystal substrate is preferably performed through the polished surface.

According to the present invention, there is provided an internally reformed substrate with a multilayer film, including: a single crystal substrate; a heat-denatured layer formed in an internal portion of the single crystal substrate by laser irradiation to the single crystal substrate; and a multilayer film including two or more layers provided on one surface of the single crystal substrate.

In an internally reformed substrate with a multilayer film according to another embodiment of the present invention, at least one of the two or more layers constituting the multilayer film is preferably a nitride semiconductor crystal layer.

According to the present invention, there is provided a semiconductor device, including the internally reformed substrate with a multilayer film according to claim 14.

In a semiconductor device according to another embodiment of the present invention, the semiconductor device preferably serves as any one of a light emitting element, an electronic device, and a light receiving element.

According to the present invention, there is provided a bulk semiconductor substrate, including the multilayer film of the internally reformed substrate with a multilayer film according to claim 14.

In a bulk semiconductor substrate according to another embodiment of the present invention, the bulk semiconductor substrate is preferably made of AlxInyGazN (x+y+z=1, x≥0, y≥0, z≥0).

According to the present invention, there is provided a manufacturing method for an internally reformed substrate for epitaxial growth, including forming a heat-denatured layer in an internal portion of a single crystal substrate by laser irradiation to the single crystal substrate.

In a manufacturing method for an internally reformed substrate for epitaxial growth according to an embodiment of the present invention, it is preferred to perform the laser irradiation so as to satisfy at least one of irradiation conditions A and B described below.

<Irradiation Condition A>
• laser wavelength: 200 nm to 400 nm
• pulse width: order of nanoseconds

### <Irradiation Condition B>

• laser wavelength: 400 nm to 5,000 nm
• pulse width: order of femtoseconds to order of picoseconds

In a manufacturing method for an internally reformed substrate for epitaxial growth according to another embodiment of the present invention, it is preferred to form the heat-denatured layer to be positioned, when a relative position of the heat-denatured layer in a thickness direction of the single crystal substrate is assumed to be 0% at one surface serving as a film formation surface and 100% at a surface opposite to the film formation surface, in a range of 3% or more and 95% or less in the thickness direction of the single crystal substrate.

In a manufacturing method for an internally reformed substrate for epitaxial growth according to still another embodiment of the present invention, it is preferred to form, in a planar direction of the single crystal substrate, the heat-denatured layer so as to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

In a manufacturing method for an internally reformed substrate for epitaxial growth according to still another embodiment of the present invention, the shape in which the plurality of polygons identical in shape and size are regularly disposed is preferably a lattice shape.

In a manufacturing method for an internally reformed substrate for epitaxial growth according to still another embodiment of the present invention, it is preferred to form the lattice shape into a pattern in which a pitch between lines constituting the pattern is in a range of 50 µm or more and 2,000 µm or less.

In a manufacturing method for an internally reformed substrate for epitaxial growth according to still another embodiment of the present invention, the single crystal substrate is preferably made of at least one material selected from sapphire, a nitride semiconductor, Si, GaAs, crystal, and SiC.

In a manufacturing method for an internally reformed substrate for epitaxial growth according to still another embodiment of the present invention, the single crystal substrate before the heat-denatured layer is formed preferably has a shape in which the film formation surface is a concave surface, and the concave surface preferably has a curvature of more than 0 km⁻¹ and 160 km⁻¹ or less.

In a manufacturing method for an internally reformed substrate for epitaxial growth according to still another embodiment of the present invention, the single crystal substrate before the heat-denatured layer is formed preferably has a shape in which the film formation surface is a concave surface, and the concave surface preferably has a curvature of more than 40 km⁻¹ and 150 km⁻¹ or less.

In a manufacturing method for an internally reformed substrate for epitaxial growth according to still another embodiment of the present invention, the single crystal substrate before the heat-denatured layer is formed preferably has a shape in which the film formation surface is a concave surface, and the concave surface preferably has a curvature of more than 85 km⁻¹ and 150 km⁻¹ or less.

In a manufacturing method for an internally reformed substrate for epitaxial growth according to still another embodiment of the present invention, the single crystal substrate preferably has a diameter of 50 mm or more and 300 mm or less.

In a manufacturing method for an internally reformed substrate for epitaxial growth according to still another embodiment of the present invention, the single crystal substrate preferably has a thickness of 0.05 mm or more and 5.0 mm or less.

In a manufacturing method for an internally reformed substrate for epitaxial growth according to still another embodiment of the present invention, the surface serving as the film formation surface of the single crystal substrate is preferably a polished surface, and it is preferred to perform the laser irradiation to the single crystal substrate through the polished surface.

According to the present invention, there is provided a manufacturing method for an internally reformed substrate with a multilayer film, including: forming a heat-denatured layer in an internal portion of a single crystal substrate by laser irradiation to the single crystal substrate; and forming a multilayer film including two or more layers provided on one surface of the single crystal substrate.

In a manufacturing method for an internally reformed substrate with a multilayer film according to another embodiment of the present invention, at least one of the two or more layers constituting the multilayer film is preferably a nitride semiconductor crystal layer.

According to the present invention, there is provided a manufacturing method for a semiconductor device, including manufacturing the semiconductor device with use of the internally reformed substrate with a multilayer film according to claim 14.

In a manufacturing method for a semiconductor device according to another embodiment of the present invention, the semiconductor device preferably serves as any one of a light emitting element, an electronic device, and a light receiving element.

According to the present invention, there is provided a manufacturing method for a bulk semiconductor substrate, including forming the bulk semiconductor substrate with use of the multilayer film of the internally reformed substrate with a multilayer film according to claim 14.

In a manufacturing method for a bulk semiconductor substrate according to another embodiment of the present invention, it is preferred to form the bulk semiconductor substrate of AlxInyGazN (x+y+z=1, x≥0, y≥0, z≥0).

### Advantageous Effects of Invention

According to the present invention described above, there may be provided an internally reformed substrate for epitaxial growth having an arbitrary warpage shape and/or an arbitrary warpage amount, an internally reformed substrate with a multilayer film using the internally reformed substrate for epitaxial growth, a semiconductor device, a bulk semiconductor substrate, and manufacturing methods therefor.

### Brief Description of Drawings

[FIG. 1] A schematic explanatory diagram illustrating an example of a manufacturing method for an internally reformed substrate for epitaxial growth according to an embodiment of the present invention.

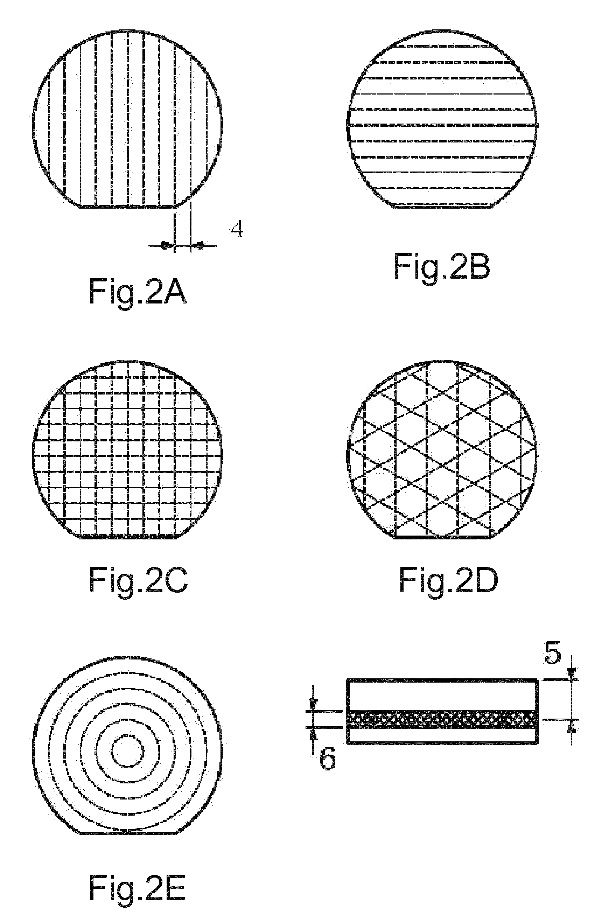

[FIGS. 2] Plan views illustrating examples of a disposition pattern shape of a heat-denatured layer in a planar direction of a single crystal substrate, of which FIG. 2A is a plan view illustrating a stripe shape in which a plurality of lines are formed perpendicular to an orientation flat plane of a substrate, FIG. 2B is a plan view illustrating a stripe shape in which a plurality of lines are formed in parallel to the orientation flat plane of the substrate, FIG. 2C is a plan view illustrating a lattice shape in which the disposition pattern shapes illustrated in FIGS. 2A and 2B are combined, FIG. 2D is a plan view illustrating a shape in which a plurality of regular hexagons identical in size are regularly disposed so that each of six vertices of each regular hexagon always coincides with any one of vertices of an adjacent regular hexagon, and FIG. 2E is a plan view illustrating a concentric shape.
[FIGS. 3] Views illustrating an epitaxial growth step of a nitride semiconductor layer as an example of a multilayer film.
[FIG. 4] A graph showing an example of an in-situ observation in the epitaxial growth step of the nitride semiconductor layer illustrated in FIGS. 3.
[FIG. 5] A view illustrating the relationship between a warpage amount of the substrate and a curvature thereof.
[FIG. 6] A graph showing an example of an in-situ observation when an internally reformed substrate with a multilayer film according to the embodiment of the present invention is formed.
[FIG. 7] A graph showing formation positions and pitch dependence with respect to a change amount of a substrate curvature after the formation of a heat-denatured layer according to Example 2 of the present invention.
[FIG. 8A] A graph showing the result of an in-situ observation of Sample 10 according to Example 3 of the present invention.
[FIG. 8B] A graph showing the result of an in-situ observation of Sample 12 according to Example 3 of the present invention.
[FIG. 8C] A graph showing the result of an in-situ observation of Sample 14 according to Example 3 of the present invention.
[FIG. 8D] A graph showing the result of an in-situ observation of Sample 16 according to Example 3 of the present invention.
[FIG. 8E] A graph showing the result of an in-situ observation of Sample 18 according to Example 3 of the present invention.
[FIG. 8F] A graph showing the result of an in-situ observation of Sample 20 according to Example 3 of the present invention.
[FIG. 9] A graph showing the result of in-situ observations of samples according to Examples 8 and 9 of the present invention.

### Reference Signs List

- 1: single crystal substrate
- 2: laser irradiation apparatus
- 3: reformed region
- 4: pitch
- 5: formation position
- 6: length of heat-denatured layer
- 7: sapphire substrate
- 8: low-temperature buffer layer
- 9: n-GaN layer
- 10: InGaN-based active layer

### Description of Embodiment

An internally reformed substrate for epitaxial growth according to an embodiment of the present invention includes: a single crystal substrate; and a heat-denatured layer formed in an internal portion of the single crystal substrate in a thickness direction thereof by laser irradiation to the single crystal substrate. Note that, when the single crystal substrate in which a surface serving as a film formation surface is a polished surface is used, it is especially preferable to perform the laser irradiation to the single crystal substrate through the polished surface.

Consequently, in accordance with the usage of the internally reformed substrate for epitaxial growth according to this embodiment, the warpage shape and/or the warpage amount are arbitrarily controlled. In addition, when a multilayer film is formed, it is possible to cancel out a stress generated by the film formation with a stress of the single crystal substrate having the heat-denatured layer formed therein, and hence it is possible to suppress the warpage of the substrate during the film formation and reduce the warpage behavior of the substrate.

Note that, the "heat-denatured layer" refers to a layer formed by locally heating a region in a part of the internal portion of the single crystal substrate in the thickness direction. When the heat-denatured layer is formed in one of regions obtained by bisecting the single crystal substrate in the thickness direction, the heat-denatured layer has the action of warping the substrate so that the surface on the side of the region on which the heat-denatured layer is formed becomes convex.

As a formation method for the heat-denatured layer, there is used a method in which the single crystal substrate is irradiated with a laser. In this case, by multiphoton absorption of atoms present in a region irradiated with the laser, the region is locally heated and some sort of denaturalization such as a change in crystal structure or crystallinity with respect to that in the surrounding region occurs. Accordingly, the heat-denatured layer is formed. That is, it is possible to manufacture the internally reformed substrate for epitaxial growth according to this embodiment by performing at least a step of forming the heat-denatured layer in the internal portion of the single crystal substrate in the thickness direction by the laser irradiation to the single crystal substrate.

### -Laser Irradiation Condition-

Note that, the irradiation of the laser may be performed under any irradiation condition as long as the heat-denatured layer can be formed. However, in general, it is preferred to use a pulsed laser that intermittently emits laser light because the pulsed laser can concentrate energy in a short time width and hence can obtain a high peak output. Thus, the irradiation of the pulsed laser is preferably performed in ranges 1) and 2) described below.
1) laser wavelength: 200 nm to 5,000 nm
2) pulse width: the order of femtoseconds to the order of nanoseconds (1 fs to 1,000 ns)

Herein, the laser wavelength and the pulse width are appropriately selected in consideration of the light transmittance/light absorption performance resulting from the material of the single crystal substrate as the target of the laser irradiation, the size and pattern precision of the heat-denatured layer formed in the single crystal substrate, and a practically usable laser apparatus. However, in the laser irradiation, it is especially preferable to select Irradiation Condition A or B described below.

### <Irradiation Condition A>

• laser wavelength: 200 nm to 400 nm
• pulse width: the order of nanoseconds (1 ns to 1,000 ns).
   Note that, more preferably, 10 ns to 15 ns.

### <Irradiation Condition B>

• laser wavelength: 400 nm to 2,000 nm
• pulse width: the order of femtoseconds to the order of picoseconds (1 fs to 1,000 ps). Note that, more preferably, 200 fs to 800 fs.

Note that, in Irradiation Condition A, the laser having the wavelength shorter than that in Irradiation Condition B is used. As a result, when the laser irradiation is performed under the same conditions except for the laser wavelength and the pulse width, Irradiation Condition A can reduce a laser process time period required to obtain substantially the same level of the effect of correcting the warpage as compared with Irradiation Condition B. In addition, as the laser wavelength to be used, it is suitable to select a wavelength longer than an absorption edge wavelength of the single crystal substrate as the target of the laser irradiation.

Herein, when the single crystal substrate is an Si substrate, Irradiation Condition B described above can be used. In this case, conditions other than the laser wavelength are preferably selected in ranges described below from the viewpoint of, for example, practicality and mass productivity.
• pulse width: 50 ns to 200 ns
• pulse rate: 10 kHz to 500 kHz
• irradiation energy: 3 µJ to 30 µJ
• laser spot size: 0.5 µm to 4.0 µm
• scanning speed of sample stage: 50 mm/s to 1, 000 mm/s (morepreferably 100 mm/s to 1,000 mm/s)

Further, when the single crystal substrate is a GaAs substrate, Irradiation Condition B described above can be used. In this case, conditions other than the laser wavelength are preferably selected in ranges described below from the viewpoint of, for example, practicality and mass productivity.
• pulse width: 30 ns to 80 ns
• pulse rate: 10 kHz to 500 kHz
• irradiation energy: 8 µJ to 20 µJ
• laser spot size: 0.5 µm to 4.0 µm
• scanning speed of sample stage: 50 mm/s to 1, 000 mm/s (morepreferably 100 mm/s to 1,000 mm/s)

Further, when the single crystal substrate is a crystal substrate, Irradiation Condition B described above can be used. In this case, conditions other than the laser wavelength are preferably selected in ranges described below from the viewpoint of, for example, practicality and mass productivity.
• pulse width: 200 fs to 800 fs
• pulse rate: 10 kHz to 500 kHz
• irradiation energy: 3 µJ to 6 µJ
• laser spot size: 0.5 µm to 4.0 µm
• scanning speed of sample stage: 50 mm/s to 1, 000 mm/s (morepreferably 100 mm/s to 1,000 mm/s)

Further, when the single crystal substrate is a lithium tantalate substrate, Irradiation Condition A described above can be used. In this case, conditions other than the laser wavelength are preferably selected in ranges described below from the viewpoint of, for example, practicality and mass productivity.
• pulse width: 200 fs to 800 fs
• pulse rate: 10 kHz to 500 kHz
• irradiation energy: 3 µJ to 6 µJ
• laser spot size: 0.5 µm to 4.0 µm
• scanning speed of sample stage: 50 mm/s to 1, 000 mm/s (morepreferably 100 mm/s to 1,000 mm/s)

Further, when the single crystal substrate is a glass substrate, Irradiation Condition A described above can be used. In this case, conditions other than the laser wavelength are preferably selected in ranges described below from the viewpoint of, for example, practicality and mass productivity.
• pulse width: 10 ns to 15 ns
• pulse rate: 10 kHz to 500 kHz
• irradiation energy: 10 µJ to 20 µJ
• laser spot size: 0.5 µm to 4.0 µm
• scanning speed of sample stage: 50 mm/s to 1, 000 mm/s (morepreferably 100 mm/s to 1,000 mm/s)

Note that, Table 1 and Table 2 show examples of laser irradiation conditions when the heat-denatured layer is formed in each of an Si substrate, a GaAs substrate, a crystal substrate, a lithium tantalate substrate, and a glass substrate. When the laser irradiation is performed, the surface of the single crystal substrate on the side to be irradiated with the laser is especially preferably in the state of a mirror plane. In order to bring the surface to be irradiated with the laser into the state of the mirror plane, for example, mirror polishing can be performed.

**[Table 1]**

| | Si | GaAs | Crystal |
|---|---|---|---|
| Wavelength (nm) | 1, 064 | 1, 064 | 1,045 |
| Pulse width (sec) | 120×10⁻⁹ | 70×10⁻⁹ | 500×10⁻¹⁵ |
| Pulse rate (kHz) | 100 | 15 | 100 |
| Spot size (µm) | 1.5 | 1.5 | 1.0 |
| Laser power (W) | 0.3 to 1.2 | 0.2 | 0.4 |
| Stage scanning speed (mm/s) | 200 to 300 | 200 | 400 |

**[Table 2]**

| | Lithiumtantalate | Glass |
|---|---|---|
| Wavelength (nm) | 355 | 355 |
| Pulse width (sec) | 10×10⁻⁹ to 15×10⁻⁹ | 10×10⁻⁹ to 15×10⁻⁹ |
| Pulse rate (kHz) | 50 | 50 |
| Spot size | 1.0 | 1.0 |
| Laser power | 0.1 to 0.5 | 0.5 to 2.0 |
| Stage scanning speed (mm/s) | 600 | 600 |

As the material constituting the single crystal substrate used in the production of the internally reformed substrate for epitaxial growth according to this embodiment, any known single crystal material capable of forming the heat-denatured layer by the laser irradiation can be used, and examples thereof include sapphire, a nitride semiconductor, Si, GaAs, crystal, SiC, and the like. When Irradiation Condition A described above is adopted, especially Si, GaAs, crystal, or SiC can be suitably used. In addition, instead of the single crystal substrate, quartz, glass, and the like may also be used.

Further, as the single crystal substrate, usually, a single crystal substrate having at least one surface subjected to the mirror polishing is used. In this case, in a subsequent epitaxial growth step, the multilayer film is formed on the side of the surface subjected to the mirror polishing. Note that, the single crystal substrate having both surfaces subjected to the mirror polishing may also be used as needed. In this case, one of the surfaces can be arbitrarily used as the film formation surface.

The shape of the single crystal substrate in the planar direction is not particularly limited, and the shape thereof may be, for example, square or the like. However, from the viewpoint of easy application to the manufacturing lines for various known elements, a circular shape is preferable, and a circular shape provided with an orientation flat plane is especially preferable.

When the shape of the single crystal substrate is the circular shape or the circular shape provided with the orientation flat plane, the diameter of the single crystal substrate is preferably 50 mm or more, more preferably 75 mm or more, and further more preferably 150 mm or more. Note that, the upper limit value of the diameter is not particularly limited, but is preferably 300 mm or less from the viewpoint of practicality.

In addition, the thickness of the single crystal substrate is preferably 5.0 mm or less, preferably 3.0 mm or less, and more preferably 2.0 mm or less. The lower limit value of the thickness is not particularly limited, but is preferably 0.05 mm or more from the viewpoint of securing the rigidity of the single crystal substrate, and more preferably 0.1 mm or more. When the shape of the single crystal substrate 20 is the circular shape or the circular shape provided with the orientation flat plane, in a case where the diameter is 50 mm or more and 150 mm or less, the thickness is preferably 0.3 mm or more and, in a case where the diameter is more than 150 mm, the thickness is preferably 0.5 mm or more.

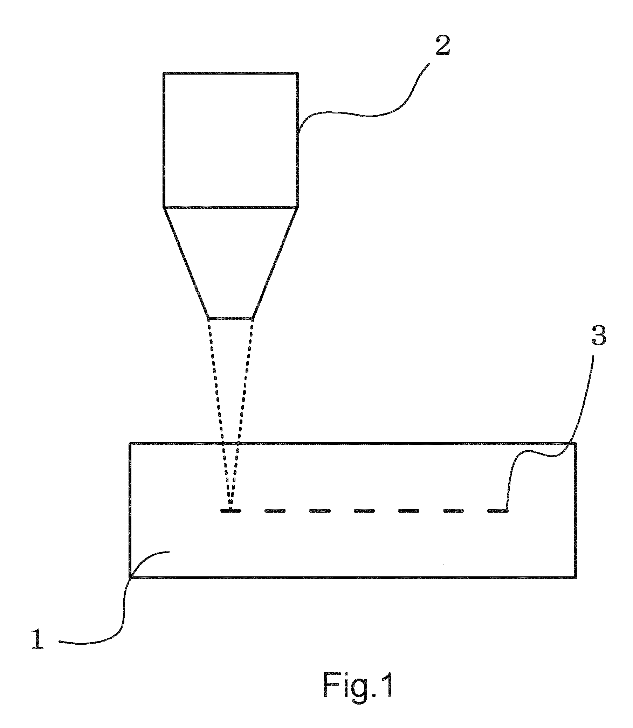

Next, a specific example of the formation of the internally reformed substrate for epitaxial growth is described with reference to the drawings. FIG. 1 is a schematic explanatory diagram illustrating an example of the manufacturing method for the internally reformed substrate for epitaxial growth according to this embodiment.

As illustrated in FIG. 1, the manufacturing method is implemented in a state in which a single crystal substrate 1 is fixed to a sample stage (not shown). Note that, the fixing is preferably performed so that the warpage of the single crystal substrate 1 can be corrected by, for example, vacuum suction or the like. Subsequently, the laser is emitted by a laser irradiation apparatus 2 from the side of the surface (film formation surface) of the single crystal substrate 1 fixed to the sample stage. At this point, the laser is concentrated onto the internal portion of the single crystal substrate 1 in the thickness direction, and the laser irradiation apparatus 2 and the single crystal substrate 1 are moved relative to each other in the horizontal direction. In this manner, spot-like reformed regions 3 (the heat-denatured layer) are formed to have a linear shape in which the spot-like reformed regions are continuously linked together.

When viewed locally, the spot-like reformed region 3 is formed only in a portion to which the laser is momentarily applied, and the size of the reformed region depends on the spot size, laser intensity, and pulse width of the laser. Through appropriate selection of the spot size, laser power, and pulse width of the laser, it is possible to control the degree of denaturalization and the size of the heat-denatured layer in the planar direction and the horizontal direction of the single crystal substrate 1. With regard to the length of the linearly formed spot-like reformed regions 3, through appropriate selection of the movement speed of the laser irradiation apparatus 1 relative to the single crystal substrate 1 (for example, when the sample stage is movable, the scanning speed of the sample stage) and the pulse rate of the laser, it is possible to control intervals of a plurality of heat-denatured layers in the planar direction of the single crystal substrate 1.

Through combination of the plurality of linearly formed reformed regions 3, at least one type of a reformed region pattern 3 constituting the heat-denatured layer is formed at a desired position in the single crystal substrate 1 in the thickness direction. The reformed region 3 is a region formed by locally causingmultiphoton absorption in a portion irradiated with the laser.

Through optimization of conditions such as the pattern shape, the formation position, and the length of the heat-denatured layer, it is possible to control the stress of the entire single crystal substrate and accurately control the warpage shape and/or the warpage amount of the single crystal substrate.

In the planar direction of the single crystal substrate, the heat-denatured layer is preferably provided to have the following pattern shapes. That is, it is preferred that, in the planar direction of the single crystal substrate, the heat-denatured layer be provided to have at least one pattern shape selected from the following shapes i) to vii):
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly symmetric with respect to a straight line passing through the center point of the single crystal substrate;
vi) a stripe shape; and
vii) a spiral shape.

In addition, when the heat-denatured layer is formed, from the viewpoint that laser scanning, that is, the movement of the laser irradiation apparatus relative to the single crystal substrate is relatively simple as compared with other pattern shapes so as to facilitate the laser process, the pattern shape is preferably i) the shape in which the plurality of polygons identical in shape and size are regularly disposed. Further, as i) the shape in which the plurality of polygons identical in shape and size are regularly disposed, a shape in which a plurality of quadrangles identical in shape and size are regularly disposed so that four sides constituting each quadrangle coincide with any one of four sides of an adjacent quadrangle, that is, a lattice shape is especially preferable. In this case, it is only necessary to perform the laser scanning in vertical and lateral directions. Thus, thelaserprocess can be further facilitated, and the designing of the warpage amount control and the shape control of the single crystal substrate can also be further facilitated.

Herein, the pitch between the lines constituting the pattern forming the lattice shape is preferably in a range of 50 µm to 2,000 µm, and more preferably in a range of 100 µm to 1,000 µm. With the setting of the pitch to 50 µm or more, it is possible to suppress an unnecessary increase in time period required for the laser process and, with the setting of the pitch to 2,000 µm or less, it is possible to more reliably correct the warpage of the single crystal substrate.

FIGS. 2 are plan views illustrating examples of the disposition pattern shape of the heat-denatured layer in the planar direction of the single crystal substrate. Specifically, FIGS. 2 illustrate examples of the disposition pattern shape of the heat-denatured layer when the planar shape of the single crystal substrate is the circular shape having the orientation flat plane. As illustrated in FIGS. 2, examples of the disposition pattern shape of the heat-denatured layer include stripe shapes (FIGS. 2A and 2B) in which a plurality of lines are formed perpendicular to or in parallel to the orientation flat plane of the substrate, and a lattice shape (FIG. 2C) obtained by combining the above-mentioned stripe shapes. In addition, other examples of the disposition pattern shape include a shape (FIG. 2D) in which a plurality of regular hexagons identical in size are regularly disposed so that each of six vertices of each regular hexagon always coincides with any one of vertices of an adjacent regular hexagon, and a concentric shape (FIG. 2E). Note that, a width 4 illustrated in FIG. 2A denotes the pitch between lines.

In the internally reformed substrate for epitaxial growth according to this embodiment, when the heat-denatured layer is provided in the internal portion of the single crystal substrate in the thickness direction, in accordance with the usage of the internally reformed substrate for epitaxial growth, the warpage shape and/or the warpage amount are arbitrarily controlled. In addition, when the multilayer film is formed, it is possible to cancel out the stress generated by the film formation with the stress of the single crystal substrate having the heat-denatured layer formed therein, and hence it is possible to suppress the warpage of the substrate during the film formation and reduce the warpage behavior of the substrate. However, when the heat-denatured layer is provided at a deviated position, irregularly disposed, or asymmetrically disposed in the thickness direction or the planar direction of the single crystal substrate, it sometimes becomes difficult to correct the warpage. In particular, the relative formation position where the heat-denatured layer is formed in the thickness direction of the single crystal substrate influences the change amount of the warpage amount of the single crystal substrate after the formation of the heat-denatured layer and, as the formation position becomes closer to the surface, the change amount is increased.

In order to avoid the occurrence of the above-mentioned problem, with regard to the thickness direction of the single crystal substrate, when a relative position 5 of the heat-denatured layer in the thickness direction of the single crystal substrate is assumed to be 0% at the surface serving as the film formation surface and 100% at the surface opposite to the film formation surface, the heat-denatured layer is preferably provided in a range of 3% or more and 95% or less in the thickness direction of the single crystal substrate, and is more preferably provided in a range of 3% or more and 50% or less. With the provision of the heat-denatured layer in the ranges of values described above in the thickness direction of the single crystal substrate, it is possible to more effectively correct the warpage of the single crystal substrate. Note that, the plurality of heat-denatured layers are preferably present all at the same position in the thickness direction of the single crystal substrate, but the heat-denatured layers may also be present at different positions. In this case, the individual heat-denatured layers may be disposed at different positions in the thickness direction of the single crystal substrate so that, with consideration given to the disposition positions of the individual heat-denatured layers in the planar direction of the single crystal substrate as well, the effect of correcting the warpage resulting from providing the heat-denatured layers is not significantly reduced. In addition, a length 6 of the heat-denatured layer in the thickness direction of the single crystal substrate is determined depending on the spot size, the irradiation energy (laser power/pulse rate), and the pulse width of the laser, and is usually in a range of several micrometers to several tens of micrometers.

As described above, when the heat-denatured layer is formed in the internal portion of the single crystal substrate to control the stress of the single crystal substrate, it is possible to obtain the internally reformed substrate for epitaxial growth in which the warpage shape and/or the warpage amount of the single crystal substrate are efficiently and accurately controlled.

In addition, the internally reformed substrate with the multilayer film according to this embodiment has a feature that the multilayer film having two or more layers is provided on the film formation surface of the internally reformed substrate for epitaxial growth obtained by the present invention.

In the description of this application, the "multilayer film" refers to a film having two or more layers. In addition to this, the "multilayer film" means a film in which each layer constituting the multilayer film is formed of continuous layers identical in film thickness in the planar direction of the single crystal substrate, and in which a film of the uppermost layer does not have a stepped portion extending through the film (this part is added in order to describe that the multilayer filmhas no electrode formation portion). The layer structure of the multilayer film, and the film thickness, the material, and the crystallinity/non-crystallinity of each layer constituting the multilayer film are appropriately selected in accordance with the type of an element to be produced by further performing a subsequent process with use of the internally reformed substrate with the multilayer film according to this embodiment and in accordance with the manufacturing process used when the element is manufactured.

The film formation method for the multilayer film is not particularly limited, and it is possible to use known film formation methods. It is also possible to adopt a different film formation method and/or a different film formation condition for each of the layers constituting the multilayer film to form the film. Examples of the film formation method include a liquid phase deposition method such as a plating method, but it is preferable to use a vapor phase deposition method such as a sputtering method or a chemical vapor deposition (CVD) method. When a semiconductor crystal layer such as a nitride semiconductor crystal layer is formed, it is more preferable to use the vapor phase deposition method such as a metal organic chemical vapor deposition (MOCVD) method, a hydride vapor phase epitaxy (HVPE) method, or a molecular beam epitaxy (MBE) method. Note that, the film formation surface of the internally reformed substrate for epitaxial growth is especially preferably in the state of the mirror plane. In order to bring the surface on which the multilayer film is formed into the state of the mirror plane, for example, mirror polishing can be performed.

In addition, at least one of the layers constituting the multilayer film is preferably a crystalline layer. In particular, at least one of the layers constituting the multilayer film is more preferably a nitride semiconductor crystal layer. Further, from the viewpoint that epitaxial growth can be caused by using the crystal plane exposed on the film formation surface of the internally reformed substrate for epitaxial growth, among the individual layers constituting the multilayer film, at least the layer that directly comes into contact with the film formation surface of the internally reformed substrate for epitaxial growth is preferably a crystalline layer, and all of the layers constituting the multilayer film may also be crystalline layers. Note that, epitaxial growth includes homoepitaxial growth and heteroepitaxial growth that include the same composition or a mixed crystal. Furthermore, the material of each layer constituting the multilayer film is also appropriately selected in accordance with the element to be produced. However, considering that the internally reformed substrate for epitaxial growth is made of an inorganic material such as a sapphire substrate, the material constituting each layer is preferably an inorganic material such as a metal material, a metal oxide material, or an inorganic semiconductor material, and all layers are desirably made of those inorganic materials. However, when the MOCVD method is used, there is a possibility that a minute amount of organic matter of an organic metal origin is mixed into the inorganic material.

Specific examples of each layer constituting the multilayer film may include, as the layer suitable for the manufacturing of elements using various types of nitride semiconductor such as a light emitting element used in a surface emitting laser or the like, a light receiving element used in an optical sensor or a solar cell, and a semiconductor element used in an electronic circuit or the like, for example, GaN-based, AlGaN-based, and InGaN-based nitride semiconductor crystal layers. In this case, as the single crystal substrate, it is suitable to use the sapphire substrate.

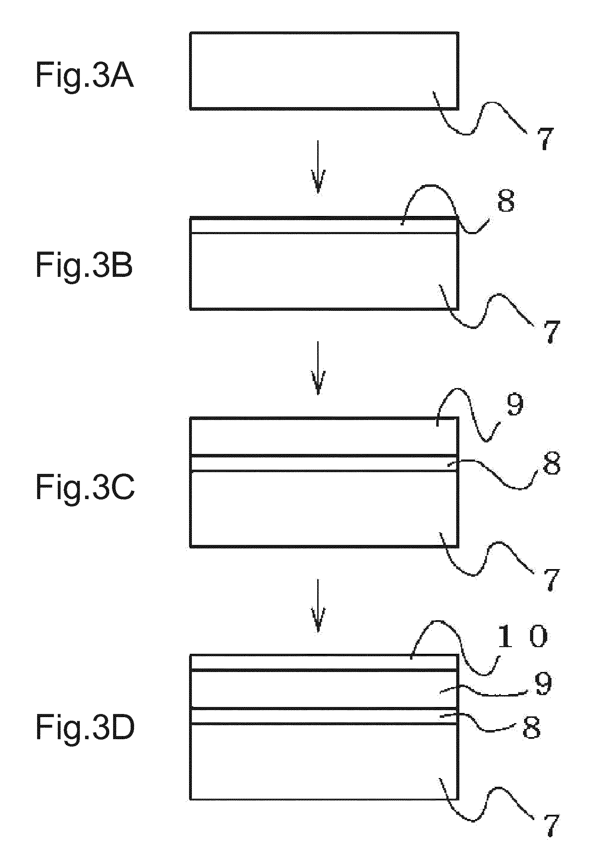

FIGS. 3 illustrate an epitaxial growth step of the nitride semiconductor layer as an example of the multilayer film.

As a specific example of the layer structure of the multilayer film, for example, as illustrated in FIGS. 3, the sapphire substrate is used as the internally reformed substrate for epitaxial growth. First, thermal cleaning of the sapphire substrate is performed (FIG. 3A) to grow a low-temperature buffer layer 8 (FIG. 3B). Subsequently, an n-GaN layer 9 (FIG. 3C) and an InGaN-based active layer 10 having a multi-quantum well structure (FIG. 3D) are grown.

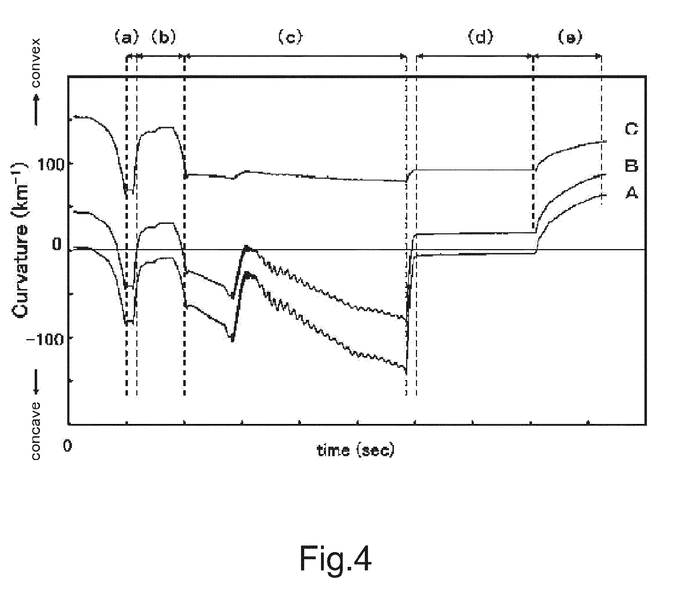

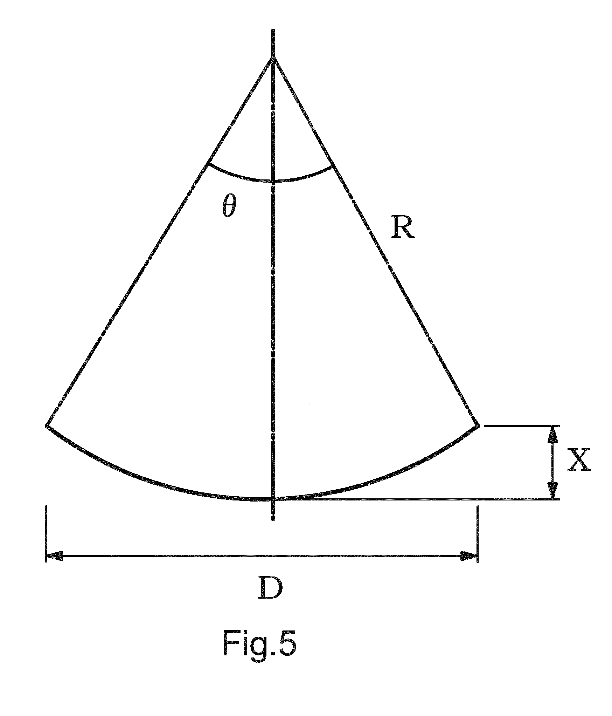

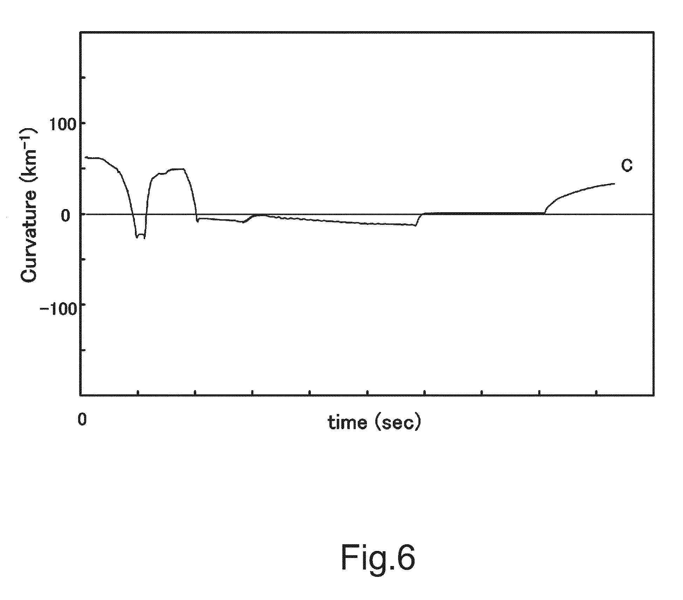

FIG. 4 shows an example of an in-situ observation in the epitaxial growth step of the nitride semiconductor layer illustrated in FIG. 3. FIG. 5 illustrates the relationship between the warpage amount and the curvature of the substrate. FIG. 6 shows an example of the in-situ observation when the internally reformed substrate with the multilayer film according to this embodiment is formed.

As disclosed in Non Patent Literature 2, it is possible to quantitatively analyze the behavior of the sapphire substrate during the film formation by the in-situ observation. That is, it is possible to know how the warpage shape and the warpage amount of the substrate are changed during the film formation. In FIG. 4, the horizontal axis indicates time, while the vertical axis indicates the curvature (km⁻¹) of the substrate on the film formation surface. The positive direction of the vertical axis indicates that the film formation surface is convex, while the negative direction thereof indicates that the film formation surface is concave.

It is possible to calculate the warpage amount of the substrate based on the curvature of the substrate. In FIG. 5, the curvature radius of the substrate is represented by R, the warpage amount of the substrate having the curvature of 1/R is represented by X, and the approximate diameter of the substrate is represented by D. With use of the Pythagorean theorem as the relationship among these values, (1/R)²= ((1/R) -X)²+ (D/2)² can be given. Based on this expression, the warpage amount (µm) can be determined as 0.322 × the curvature (km⁻¹) when the diameter of the substrate is 50 mm, and the warpage amount (µm) can be determined as 1.250 × the curvature (km⁻¹) when the diameter of the substrate is 100 mm.

SpectrumA in FIG. 4 shows an example where a conventional sapphire substrate in which the heat-denatured layer is not formed is used.

In addition, parts (a) to (e) of FIG. 4 correspond to respective processes of the film formation step. That is, the parts respectively correspond to (a) the thermal cleaning of the substrate, (b) the growth of the low-temperature buffer layer, (c) the growth of the n-GaN layer, (d) the growth of the InGaN-based active layer, and (e) cooling down.

With reference to Spectrum A of FIG. 4, the behavior of the substrate in each of the parts (a) to (e) of FIG. 4 is described.

At the stage of proceeding to (a) the thermal cleaning of the substrate, due to a difference in temperature between the upper and lower surfaces of the sapphire substrate, the concave shape of the substrate growth surface becomes steeper, and the curvature is significantly changed.

Subsequently, the temperature is usually reduced to about 500°C to 600°C and, at the stage of proceeding to (b) the growth of the low-temperature buffer layer, the concave shape of the substrate becomes gentler, and the curvature is slightly reduced.

Then, the temperature is increased to about 1, 000°C again and, at the stage of performing (c) the growth of the n-GaN layer, due to a difference in lattice constant between gallium nitride and sapphire, the concave shape of the substrate becomes steeper, and the curvature is increased. As the film formation progresses further and the film thickness is increased, the curvature is increased so that the uniformity of each of the film thickness and the film quality in the surface of the substrate are significantly deteriorated. It is said that it is technically difficult to control the uniformity in the surface of the substrate only by using film formation conditions. In addition, there is a problem that dislocation occurs in the nitride semiconductor layer in order to relieve the stress and the film quality is thereby deteriorated.

Next, the temperature is reduced to about 700°C to 800°C and, at the stage of (d) the growth of the InGaN-based active layer, the uniformity of each of the film thickness of the InGaN-based active layer and an In composition in InGaN influences the in-surface uniformity of the emission wavelength so that the manufacturing yield of an LED chip is affected. The film thickness and the In composition of the InGaN layer are influenced by the film formation temperature, and hence, in order to improve the uniformity of the temperature in the surface of the substrate, it is ideal to cause the curvature of the substrate during the film formation to approach 0 as much as possible.

Finally, at the stage of (e) cooling down of the substrate, the substrate shape is significantly warped again due to a difference in thermal expansion coefficient again so that the curvature of the substrate after a series of film formation step is finished is large. This leads to a problem that back grinding and photolithography before the LED chip is produced become difficult.

Thus, as indicated by Spectrum A of FIG. 4, it can be seen that, when the conventional sapphire substrate is used, while it is possible to set the substrate curvature at the stage of the growth of the InGaN-based active layer to substantially 0, there is a disadvantage that the behavior of the substrate during the film formation is large and the curvature of the substrate after the film formation is increased.

Next, Spectrum B in FIG. 4 shows a first example of the in-situ when the internally reformed substrate for epitaxial growth of the present invention is produced by forming the reformed region pattern in the internal portion of the conventional sapphire substrate, and the nitride semiconductor layer is formed.

In the initial state of the internally reformed sapphire substrate in the case of Spectrum B, the reformed region pattern is preferably formed so that the film formation surface is warped more convexly than that of the conventional sapphire substrate. With this, it is possible to reduce the warpage behavior of the substrate as compared with the case of Spectrum A using the conventional sapphire substrate.

Spectrum C in FIG. 4 shows an example that uses the internally reformed sapphire substrate that is warped more convexly than that of Spectrum B in its initial state by adjusting the pitch between lines and the pattern formation position when the reformed region pattern is formed in the internal portion of the conventional sapphire substrate, similarly to the case of Spectrum B.

In the case of Spectrum C, the behavior of the substrate can be further reduced through the film formation step. That is, Spectrum C shows that the effect of canceling out the stress occurring during the film formation by the stress of the substrate is larger than those of Spectrums A and B.

In the nitride semiconductor layer obtained in the case of Spectrum B or C described above, the warpage of the substrate during the film formation is suppressed and the warpage behavior of the substrate is reduced as compared with the case where the conventional sapphire substrate is used, and hence the quality and the uniformity of the film are improved.

However, at the same time, a problem occurs that the internally reformed substrate for epitaxial growth is significantly warped convexly in the initial state so that the curvatures of the substrate at the stage of the growth of the InGaN-based active layer and at the time of the end of the film formation become larger than those in the case where the conventional sapphire substrate is used.

That is, as shown by Spectrum C in FIG. 6, it is desired that the internally reformed substrate for epitaxial growth of the present invention have the initial state capable of reducing the warpage behavior of the substrate and also reducing the curvatures of the substrate at the stage of the growth of the InGaN-based active layer and at the time of the end of the film formation.

With this, it is possible to improve the quality and the uniformity of the film of the nitride semiconductor layer and also improve the uniformity of the emission wavelength of the nitride semiconductor light emitting element.

Accordingly, as the sapphire substrate before the heat-denatured layer is formed, it is desired to use such a sapphire substrate that preliminarily cancels out the curvature of the substrate generated when the substrate is significantly warped convexly due to the formation of the heat-denatured layer.

As described above, as the sapphire substrate for the formation of the heat-denatured layer, it is possible to use the sapphire substrate in which the film formation surface of the nitride semiconductor layer is the concave surface and the curvature of the concave surface is more than 0 km⁻¹ and 160 km⁻¹ or less. In addition, because of the above-mentioned reason, the film formation surface of the nitride semiconductor layer is the concave surface, and the curvature of the concave surface is preferably 40 km⁻¹ or more and 150 km⁻¹ or less and more preferably 85 km⁻¹ or more and 150 km⁻¹ or less.

As has been described thus far, with use of the internally reformed substrate for epitaxial growth of the present invention, it is possible to obtain the internally reformed substrate with the multilayerfilmincludingthe nitride semiconductor layer having the improved quality and uniformity of the film thereof.

When various semiconductor devices are formed by using the internally reformed substrate with the multilayer film obtained by the present invention, it is possible to improve the quality and the yield of each device. An example of the semiconductor device includes a light emitting element, an electronic device, or a light receiving element.

In the manufacturing of the element as the semiconductor device, besides the element portion formation step, a polishing step, a line-for-division formation step, and a division step may be performed in the stated order as subsequent steps.

In this case, in a manufacturing method for an element using the internally reformed substrate with a multilayer film according to this embodiment, specifically, by successively performing at least steps (1) to (4) described below, it is possible to produce the element including the element portion and the single crystal substrate having the size substantially corresponding to the element portion.
(1) An element portion formation step of patterning the multilayer film of the internally reformed substrate with a multilayer film according to this embodiment to form individual element portions.
(2) A polishing step of polishing, at least until the heat-denatured layer is removed, the surface of the single crystal substrate with the element portions on which the element portions are not formed, the single crystal substrate with the element portions having the element portions formed on the one surface thereof.
(3) A line-for-division formation step of applying a laser along a boundary line between the individual element portions from the side of the surface polished in the polishing step to form a line for division.
(4) A division step of applying an external force along the line for division formed in the line-for-division formation step to divide the single crystal substrate with the element portions based on each element portion.
   Herein, when (3) the line-for-division formation step and (4) the division step are performed, it is possible to use the technology described in Patent Literature 3.

Note that, when the heat-denatured layer is formed into the lattice pattern, it is theoretically possible to perform the division step by using, after the heat-denatured layer is polished in the polishing step to such an extent that the heat-denatured layer is not completely removed, the heat-denatured layer remaining in the single crystal substrate as the line for division. However, it is not possible to confirm the positions at which the element portions are present and to perform alignment for the laser irradiation before the multilayer film is individualized into individual element portions. Consequently, in the above-mentioned method in which the heat-denatured layer functioning also as the line for division is formed before the individual element portions are produced, it is difficult to accurately form the line for division in correspondence to the individual element portions. That is, in the above-mentioned method, the line for division is more prone to be deviated from the boundary line between two adjacent element portions. Thus, the above-mentioned method tends to lack practicality. Consequently, when the division step is performed by using the heat-denatured layer formed by the laser irradiation, it is especially preferable to perform the above-mentioned steps (1) to (4) in this order.

In addition, it is possible to use the internally reformed substrate with the multilayer film of the present invention as a base material further to form, by homoepitaxial growth, a thick crystalline film having such a thickness that the crystalline film is capable of free-standing. Further, it is possible to separate the thick crystalline film from the base material made of a crystal film-forming body to obtain a bulk substrate.

Further, through formation of the thick crystalline film on the internally reformed substrate for epitaxial growth of the present invention and separation of the thick film from the internally reformed substrate for epitaxial growth, it is also possible to obtain the bulk substrate made of the thick crystalline film. When the internally reformed substrate for epitaxial growth of the present invention is used, it is possible to suppress the warpage of the substrate that occurs during or after the film formation, and hence it is possible to form the thick film without causing cracks. For example, when the thick film formed of the above-mentioned nitride semiconductor layer is formed on the internally reformed substrate for epitaxial growth, it is possible to suppress the warpage of the substrate that occurs during or after the film formation. Accordingly, it is possible to obtain, without causing the cracks, the thick film formed of the nitride semiconductor layer having such a thickness that the thick film is capable of free-standing. Through separation of the thick film formed of the nitride semiconductor layer obtained in this manner from the internally reformed substrate, it is possible to obtain the bulk nitride semiconductor substrate without using a complicated step. As the bulk nitride semiconductor substrate, particularly the bulk nitride semiconductor substrate made of AlxInyGazN (x+y+z=1, x≥0, y≥0, z≥0) can be efficiently manufactured.

The film thickness for free-standing is preferably 50 µm or more. In addition, as the method for forming the thick film, for example, the MOCVD method, the HVPE method, and an LPE method can be used.

### Examples

The present invention is described hereinbelow by using Examples, but the present invention is not limited only to the following Examples. With use of laser conditions shown in Table 3, the heat-denatured layer was formed in the internal portion of the sapphire substrate and influences on changes in the warpage shape and the warpage amount of the substrate were examined. The results are described in Examples 1 and 2.

**[Table 3]**

| | |
|---|---|
| Wavelength | 1,045 nm |
| Pulse width | 500 fs |
| Pulse rate | 100 kHz |
| Spot size | 1.6 µm to 3. 5 µm |
| Laser power | 0.3 W |
| Stage scanning speed | 400 mm/s |

### (Example 1)

As the sapphire substrate in which the heat-denatured layer was to be formed, a 2-inch sapphire substrate having one polished surface was used. The thickness of the substrate was 430 µm. The warpage shape and the warpage amount of the substrate before the formation of the heat-denatured layer were measured using a laser interferometer.

Subsequently, the sapphire substrate was placed on a sample stage of a pulsed laser apparatus, and the reformed region pattern formation in the internal portion of the sapphire substrate was performed.

Table 4 shows the pattern shape, the pitch between lines, the formation position, the length of the heat-denatured layer, and a process time period per piece for each of Samples 1 to 9. The shape of the sapphire substrate after the formation of the reformed region pattern was measured using the laser interferometer, and the warpage amount and the substrate thickness were measured using a linear gauge and the laser interferometer. In Table 4, ⊥O.F. represents being perpendicular to the orientation flat plane of the sapphire substrate, while //O. F. represents being in parallel to the orientation flat plane.

**[Table 4]**

| Sample No. | Pattern shape | Pitch (µm) | Formation position (µm) | Denatured layer length (µm) | Process time period (min) |
|---|---|---|---|---|---|
| No. 1 | Stripe (⊥O.F.) | 100 µm | 110 µm | 25 µm | 5 |
| No. 2 | | | 230 µm | 30 µm | 5 |
| No. 3 | | | 350 µm | 40 µm | 5 |
| No. 4 | Stripe (//O.F.) | | 110 µm | 25 µm | 5 |
| No. 5 | | | 230 µm | 30 µm | 5 |
| No. 6 | | | 350 µm | 40 µm | 5 |
| No. 7 | Lattice | | 110 µm | 25 µm | 10 |
| No. 8 | | | 230 µm | 30 µm | 10 |
| No. 9 | | | 350 µm | 40 µm | 10 |

Table 5 shows the warpage shape and the warpage amount of the substrate before and after the formation of the reformed region pattern, and the symmetry of the warpage shape in the surface of the substrate after the formation of the heat-denatured layer. As the warpage shape of the substrate, the shape on the film formation surface side is shown.

**[Table 5]**

| Sample No. | Before pattern formation | | Before pattern formation | | |
|---|---|---|---|---|---|
| | Shape | Warpage amount (µm) | Shape | Warpage amount (µm) | Symmetry |
| No. 1 | Concave | 3 | Convex | 40 | Shape in direction in parallel to O.F. is changed |
| No. 2 | Concave | 4 | Concave | 4 | |
| No. 3 | Concave | 5 | Concave | 20 | |
| No. 4 | Concave | 4 | Convex | 40 | Shape in direction in perpendicular to O.F. is changed |
| No. 5 | Concave | 3 | Concave | 3 | |
| No. 6 | Concave | 5 | Concave | 20 | |
| No. 7 | Concave | 2 | Convex | 40 | Concentrically changed |
| No. 8 | Concave | 2 | Concave | 2 | |
| No. 9 | Concave | 3 | Concave | 20 | |

### (Example 2)

As the sapphire substrate in which the internal reformed region pattern was to be formed, a 4-inch sapphire substrate having one polished surface was used. The thickness of the substrate was 650 µm. As in Example 1, the warpage shape and the warpage amount of the substrate before the formation of the reformed region pattern were measured using a laser interferometer.

Subsequently, the sapphire substrate was placed on a sample stage of a pulsed laser apparatus, and the heat-denatured layer was formed in the internal portion of the sapphire substrate. Table 6 shows the shape, the pitch, and the formation position of the heat-denatured layer for each of Samples 10 to 19.

**[Table 6]**

| Sample No. | Pattern shape | Pitch (µm) | Formation position (µm) |
|---|---|---|---|
| No. 10 | Lattice | 500 | 110 |
| No. 11 | | 500 | 110 |
| No. 12 | | 500 | 340 |
| No. 13 | | 500 | 340 |
| No. 14 | | 500 | 570 |
| No. 15 | | 500 | 570 |
| No. 16 | | 500 and 500 | 110 and 570 |
| No. 17 | | 500 and 500 | 110 and 570 |
| No. 18 | | 500 and 250 | 110 and 570 |
| No. 19 | | 430 | 110 |

The warpage shape of the substrate after the formation of the heat-denatured layer was measured using the laser interferometer, and the warpage amount was measured using a linear gauge. Table 7 shows the substrate shape, the warpage amount, and the curvature calculated from the warpage amount before and after the formation of the heat-denatured layer in comparison with one another. As the warpage shape of the substrate, the shape on the film formation surface side is shown.

**[Table 7]**

| Sample No. | Before pattern formation | | | Before pattern formation | | |
|---|---|---|---|---|---|---|
| | Shape | Warpage amount (µm) | Curvature (km⁻¹) | Shape | Warpage amount (µm) | Curvature (km⁻¹) |
| No. 10 | Concave | 7 | 5.6 | Convex | 47 | 37.6 |
| No. 11 | Concave | 7 | 5.6 | Convex | 52 | 41.6 |
| No. 12 | Concave | 14 | 11.2 | Concave | 10 | 8 |
| No. 13 | Concave | 6 | 4.8 | Concave | 8 | 6.4 |
| No. 14 | Concave | 8 | 6.4 | Concave | 12 | 9.6 |
| No. 15 | Concave | 9 | 7.2 | Concave | 11 | 8.8 |
| No. 16 | Concave | 8 | 6.4 | Convex | 50 | 40 |
| No. 17 | Concave | 10 | 8 | Convex | 46 | 36.8 |
| No. 18 | Concave | 9 | 7.2 | Convex | 47 | 37.6 |
| No. 19 | Concave | 7 | 5.6 | Convex | 63 | 50.4 |

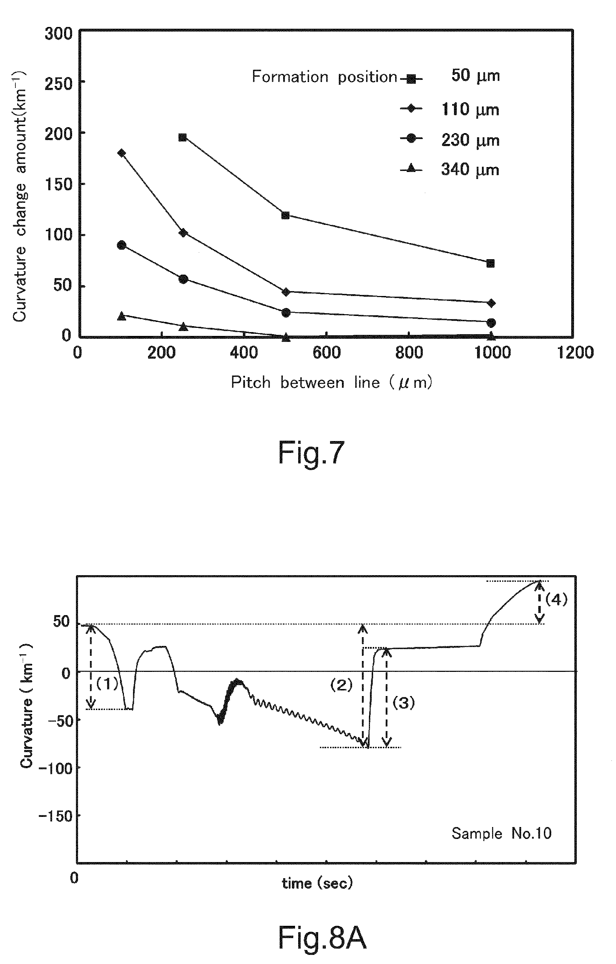

In addition, FIG. 7 shows the formation positions and dependence on the pitch between lines with respect to the change amount of the substrate curvature after the formation of the heat-denatured layer.

### (Example 3)

Among the sapphire substrates in each of which the heat-denatured layer was formed in Example 2, Samples 10, 12, 14, 16, and 18 and the conventional sapphire substrate (referred to as Sample 20) in which the heat-denatured layer was not formed were simultaneously introduced into an MOCVD apparatus, and the growth of a gallium nitride layer on each sapphire substrate was performed. Table 8 shows a growth temperature and a film thickness in each film formation step.

**[Table 8]**

| | Growth temperature (°C) | Film thickness (nm) |
|---|---|---|
| AlGaN buffer layer | 550 | 500 |
| n-GaN layer | 1,070 | 5,000 |
| GaN/InGaN active layer | 750 | 100/2 |

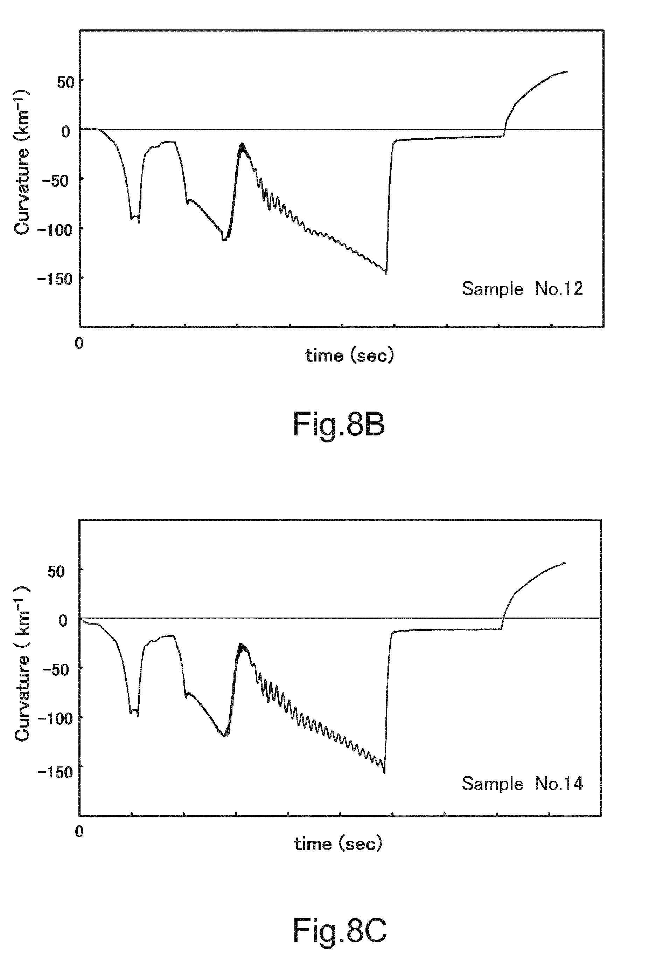

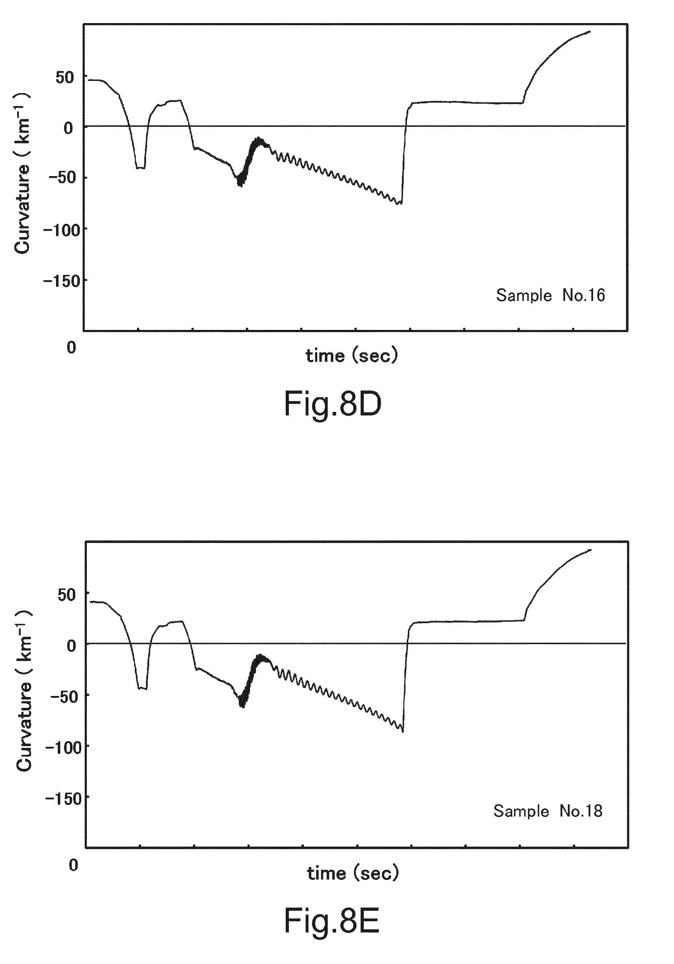

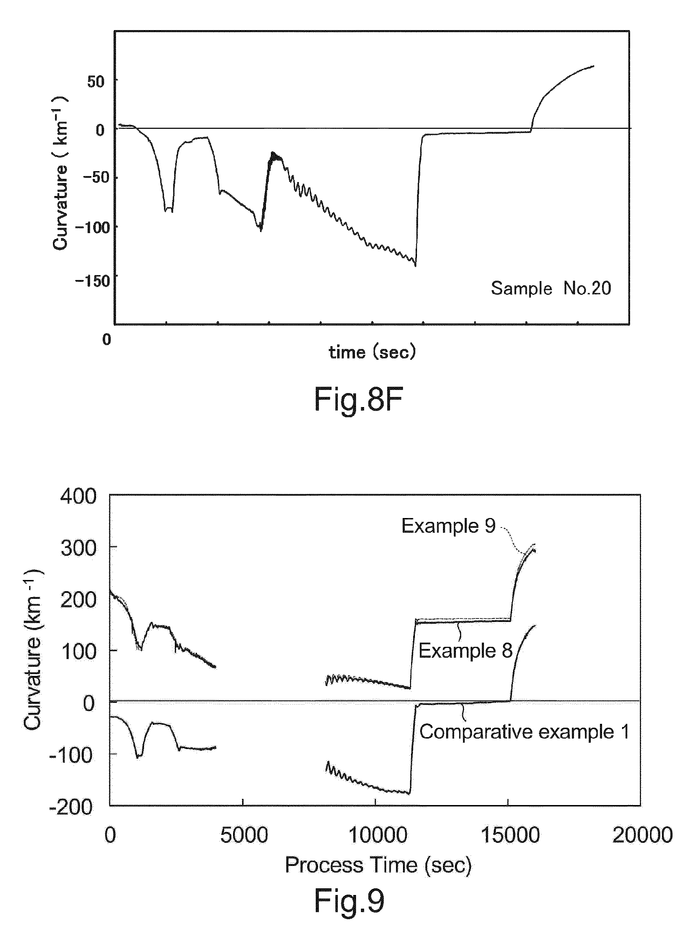

Each of FIGS. 8A to 8F shows the result of the in-situ observation of each Sample. Table 9 shows the warpage shape, the warpage amount, and the curvature of the substrate of each Sample. Table 10 shows the change amount of the substrate curvature at each stage.

As shown in FIG. 8A, columns (1) to (4) in Table 10 show the change amounts of the curvature (1) at the time of proceeding to thermal cleaning in the initial state of the substrate, (2) at the time of the growth of the n-GaN layer in the initial state of the substrate, (3) at the time of proceeding to the growth of the GaN/InGaN active layer at the time of the end of the n-GaN growth, and (4) after the end of cooling down in the initial state of the substrate, respectively.

**[Table 9]**

| Sample No. | Substrate shape | Warpage amount (µm) | Curvature (km⁻¹) |
|---|---|---|---|
| No. 10 | Convex | 47 | 37.6 |
| No. 12 | Concave | 10 | 8 |
| No. 14 | Concave | 12 | 9.6 |
| No. 16 | Convex | 50 | 40 |
| No. 18 | Convex | 47 | 36.8 |
| No. 20 | Concave | 2 | 1.6 |

**[Table 10]**

| Sample No. | Curvature change amount (km⁻¹) | | | |
|---|---|---|---|---|
| | (1) At the time of proceeding to thermal cleaning in the initial state of the substrate | (2) At the time of the growth of the n-GaN layer in the initial state of the substrate | (3) At the time of proceeding to the growth of the GaN/InGaN active layer at the time of the end of the n-GaN growth | (4) After the end of cooling down in the initial state of the substrate |
| No. 10 | 88 | 126 | 101 | 44 |
| No. 12 | 89 | 142 | 131 | 58 |
| No. 14 | 90 | 144 | 134 | 59 |
| No. 16 | 86 | 121 | 101 | 50 |
| No. 18 | 85 | 119 | 97 | 48 |
| No. 20 | 85 | 138 | 129 | 60 |

(1) Judged from the change amount of the substrate curvature at the time of proceeding to thermal cleaning from the initial state of the substrate, a significant difference in the change amount of the curvature between each of Samples 10, 12, 14, 16, and 18 in each of which the heat-denatured layer was formed and Sample 20 in which the heat-denatured layer was not formed was not observed.

(2) Judged from the change amount of the substrate curvature at the time of the growth of the n-GaN layer in the initial state of the substrate, in Samples 10, 16, and 18 in each of which the heat-denatured layer was formed at a shallow position from the surface of the sapphire substrate, as compared with other Samples, the effect of suppressing the change amount of the substrate curvature at the time of the n-GaN growth was observed.

(3) Judged from the change amount of the substrate curvature at the time of proceeding to the growth of the GaN/InGaN active layer at the time of the end of the n-GaN growth, at the stage of proceeding to the growth of the GaN/InGaN active layer from the time of the end of the growth of the n-GaN layer, in Samples 10, 16, and 18 in each of which the heat-denatured layer was formed at the shallow position from the surface of the sapphire substrate, as compared with other Samples, the effect of suppressing the change amount of the substrate curvature was observed.

(4) Judged from the change amount of the substrate curvature after the end of cooling down in the initial state of the substrate, in Samples 10, 16, and 18 in each of which the heat-denatured layer was formed at the shallow position from the surface of the sapphire substrate, as compared with other Samples, the effect of suppressing the change amount of the substrate curvature was observed.

The uniformity of the film thickness and the crystal quality of the gallium nitride layer of each of Samples 10, 12, 14, 16, 18, and 20 obtained by the above-mentioned steps were examined.

In Sample 10, it was found that the uniformity of the film thickness was improved as compared with Sample 20 in which the heat-denatured layer was not formed. This is probably because the growth of the n-GaN layer was performed in a state in which the substrate shape was flatter due to the formation of the heat-denatured layer at the shallow position from the surface of the sapphire substrate.

Further, FWHM values of the (001) plane and the (102) plane of the gallium nitride layer determined by X-ray diffraction rocking curve measurement were 203 arcsec and 418 arcsec respectively in Sample 10, while those values were 242 arcsec and 579 arcsec respectively in Sample 20 in which the heat-denatured layer was not formed. From this result, it was found that the crystallinity of the gallium nitride layer was improved in Sample 10 in which the heat-denatured layer was formed as compared with Sample 20 in which the heat-denatured layer was not formed.

Next, with use of laser conditions shown in Table 11, the heat-denatured layer was formed in the internal portion of the sapphire substrate, and influences with respect to changes in the warpage shape and the warpage amount of the substrate were examined. Examples 4 and 6 describe the results. On the other hand, with use of laser conditions shown in Table 3, the heat-denatured layer was formed in the internal portion of the same sapphire substrate, and influences with respect to changes in the warpage shape and the warpage amount of the substrate were examined. Examples 5 and 7 describe the results.

**[Table 11]**

| | |
|---|---|
| Wavelength (nm) | 355 |
| Pulse width (sec) | 10 × 10⁻⁹ to 15 × 10⁻⁹ |
| Pulse rate (kHz) | 50 |
| Spot size (µm) | 1.0 |
| Laser power (W) | 0.1 to 0.5 |
| Stage scanning speed (mm/s) | 600 |

### (Examples 4 and 5)

As the sapphire substrate in which the heat-denatured layer was to be formed, a 2-inch substrate having one polished surface was used. The thickness of the substrate was 430 µm. The warpage shape and the warpage amount of the substrate before the formation of the heat-denatured layer were measured using a laser interferometer.

Subsequently, two sapphire substrates described above were respectively placed on sample stages of a UV laser apparatus having the laser conditions shown in Table 11 and an Fs laser apparatus having the laser conditions shown in Table 3, and the formation of the heat-denatured layer in the internal portion of each of the sapphire substrates was performed.

Table 12 shows the pitch between lines, the formation position, and a pulse interval of the laser in each of Examples 4 and 5. The shape of the sapphire substrate before and after the formation of the heat-denatured layer was measured using the laser interferometer, while the warpage amount and the substrate thickness were measured using the linear gauge and the laser interferometer.

**[Table 12]**

| | Process laser | Laser process conditions | | |
|---|---|---|---|---|
| | | Process pitch (µm) | Pulse interval (µm) | Process depth from substrate surface (µm) |
| Example 4 | UV laser | 200 | 4 | 110 |
| Example 5 | Fs laser | 200 | 4 | 110 |

of the substrate before and after the formation of the heat-denatured layer. As the warpage shape of the substrate, the shape on the film formation surface side is shown.

**[Table 13]**

| | Process laser | Before process | | After process | |
|---|---|---|---|---|---|
| | | Warpage (µm) | Shape | Warpage (µm) | Shape |
| Example 4 | UV laser | 5 | Concave | 116 | Convex |
| Example 5 | Fs laser | 5 | Concave | 85 | Convex |

### (Examples 6 and 7)

As the sapphire substrate in which the heat-denatured layer was to be formed, a 2-inch substrate having one polished surface was used. The thickness of the substrate was 430 µm. The warpage shape and the warpage amount of the substrate before the formation of the heat-denatured layer were measured using a laser interferometer.

Subsequently, two sapphire substrates described above were respectively placed on sample stages of the UV laser apparatus having the laser conditions shown in Table 11 and the Fs laser apparatus having the laser conditions shown in Table 3, and the formation of the heat-denatured layer in the internal portion of each of the sapphire substrates was performed.

Table 14 shows the pitch between lines, the formation position, and a pulse interval of the laser in each of Examples 6 and 7. The shape of the sapphire substrate before and after the formation of the heat-denatured layer was measured using the laser interferometer, while the warpage amount and the substrate thickness were measured using the linear gauge and the laser interferometer.

**[Table 14]**

| | Process laser | Laser process conditions | | |
|---|---|---|---|---|
| | | Process pitch (µm) | Pulse interval (µm) | Process depth from substrate surface (µm) |
| Example 6 | UV laser | 200 | 8 | 110 |
| Example 7 | Fs laser | 200 | 4 | 110 |

Table 15 shows the warpage shape and the warpage amount of the substrate before and after the formation of the heat-denatured layer. As the warpage shape of the substrate, the shape on the film formation surface side is shown.

**[Table 15]**

| | Process laser | Before process | | After process | |
|---|---|---|---|---|---|
| | | Warpage (µm) | Shape | Warpage (µm) | Shape |
| Example 6 | UV laser | 5 | Concave | 62 | Convex |
| Example 7 | Fs laser | 5 | Concave | 62 | Convex |

In the case of Example 4 in which the UV laser having the pulse width of 10 ns to 15 ns is used, the laser energy resulting from the laser wavelength is large so that the width of the process line to be formed is large. As compared with Example 5, the warpage amount of the substrate alone is further increased in the UV laser process under the same process conditions so that the effect of correcting the warpage resulting from the formation of the multilayer film is correspondingly larger. Consequently, it was proved that, in a case where the same warpage effect of the substrate alone was obtained, the process time period was able to be reduced by using the UV laser. As the result, it is possible to reduce the manufacturing cost of the internally reformed substrate for epitaxial growth.

In the case of Example 6 in which the UV laser having the pulse width of 10 ns to 15 ns is used, because of the same reason as described above, the process line of the laser irradiation is thick. Accordingly, as compared with Example 7, the process time period required to obtain the same warpage effect of the substrate alone was reduced. As the result, it is possible to reduce the manufacturing cost of the internally reformed substrate for epitaxial growth.

### (Examples 8 and 9)

The sapphire substrates in each of which the heat-denatured layer was formed in Examples 6 and 7 and the sapphire substrate in which the heat-denatured layer was not formed were simultaneously introduced into the MOCVD apparatus, and the growth of the gallium nitride layer on each substrate was performed. The growth temperature and the film thickness in each film formation step are the same as the conditions shown in Table 8 described above.

FIG. 9 shows the result of the in-situ observation, and Table 16 shows the warpage shape and the warpage amount of each substrate after the film formation.

**[Table 16]**

| | Process laser | Before film formation | | | | After film formation | | |
|---|---|---|---|---|---|---|---|---|
| | | Before process | | After process | | | | |
| | | Warpage (µm) | Shape | Warpage (µm) | Shape | Warpage (µm) | Shape | Curvature (km ¹) |
| Example 8 | UV laser | 5 | Concave | 62 | Convex | 96 | Convex | 300 |
| Example 9 | Fs laser | 5 | Concave | 62 | Convex | 96 | Convex | 300 |
| Comparative Example 1 | No process | 5 | Concave | - | - | 48 | | 175 |

As shown in FIG. 9 and Table 16, as compared with the internally reformed substrate for epitaxial growth in which the heat-denatured layer was formed with use of the Fs laser irradiation, it was confirmed that the internally reformed substrate for epitaxial growth in which the heat-denatured layer was formed with use of the UV laser irradiation had the similar effect of suppressing the substrate behavior even during the epitaxial growth of the gallium nitride layer on the substrate. In addition, a fracture caused by an internal crack resulting from strong UV laser irradiation did not occur either.

From the result described above, it was found that, when the epitaxial growth of the nitride semiconductor layer was performed by using the internally reformed substrate for epitaxial growth of the present invention, it was possible to suppress the warpage of the substrate and reduce the warpage behavior of the substrate, and hence the quality and the uniformity of the film were improved.

## Claims

1. An internally reformed substrate for epitaxial growth, comprising:
a single crystal substrate; and
a heat-denatured layer formed in an internal portion of the single crystal substrate by laser irradiation to the single crystal substrate.

2. An internally reformed substrate for epitaxial growth according to claim 1, wherein the laser irradiation is performed so as to satisfy at least one of irradiation conditions A and B described below.
<Irradiation Condition A>
• laser wavelength: 200 nm to 400 nm
• pulse width: order of nanoseconds
<Irradiation Condition B>
• laser wavelength: 400 nm to 5,000 nm
• pulse width: order of femtoseconds to order of picoseconds

3. An internally reformed substrate for epitaxial growth according to claim 1 or 2, wherein, when a relative position of the heat-denatured layer in a thickness direction of the single crystal substrate is assumed to be 0% at one surface serving as a film formation surface and 100% at a surface opposite to the film formation surface, the heat-denatured layer is provided in a range of 3% or more and 95% or less in the thickness direction of the single crystal substrate.

4. An internally reformed substrate for epitaxial growth according to any one of claims 1 to 3, wherein, in a planar direction of the single crystal substrate, the heat-denatured layer is provided to have at least one pattern shape selected from the following shapes:
i) a shape in which a plurality of polygons identical in shape and size are regularly disposed;
ii) a shape in which a plurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

5. An internally reformed substrate for epitaxial growth according to claim 4, wherein the shape in which the plurality of polygons identical in shape and size are regularly disposed comprises a lattice shape.

6. An internally reformed substrate for epitaxial growth according to claim 5, wherein the lattice shape is formed of a pattern in which a pitch between lines constituting the pattern is in a range of 50 µm or more and 2,000 µm or less.

7. An internally reformed substrate for epitaxial growth according to any one of claims 1 to 6, wherein the single crystal substrate is made of at least one material selected from sapphire, nitride semiconductor, Si, GaAs, crystal, and SiC.

8. An internally reformed substrate for epitaxial growth according to any one of claims 1 to 7,
wherein the single crystal substrate before the heat-denatured layer is formed has a shape in which the film formation surface comprises a concave surface, and
wherein the concave surface has a curvature of more than 0 km⁻¹ and 160 km⁻¹ or less.

9. An internally reformed substrate for epitaxial growth according to any one of claims 1 to 7, wherein the concave surface has a curvature of 40 km⁻¹ or more and 150 km⁻¹ or less.

10. An internally reformed substrate for epitaxial growth according to any one of claims 1 to 7, wherein the concave surface has a curvature of 85 km⁻¹ or more and 150 km⁻¹ or less.

11. An internally reformed substrate for epitaxial growth according to any one of claims 1 to 10, wherein the single crystal substrate has a diameter of 50 mm or more and 300 mm or less.

12. An internally reformed substrate for epitaxial growth according to any one of claims 1 to 11, wherein the single crystal substrate has a thickness of 0.05 mm or more and 5.0 mm or less.

13. An internally reformed substrate for epitaxial growth according to any one of claims 1 to 12,
wherein the surface serving as the film formation surface of the single crystal substrate comprises a polished surface, and
wherein the laser irradiation to the single crystal substrate is performed through the polished surface.

14. An internally reformed substrate with a multilayer film, comprising:
a single crystal substrate;
a heat-denatured layer formed in an internal portion of the single crystal substrate by laser irradiation to the single crystal substrate; and
a multilayer film comprising two or more layers provided on one surface of the single crystal substrate.

15. An internally reformed substrate with a multilayer film according to claim 14, wherein at least one of the two or more layers constituting the multilayer film comprises a nitride semiconductor crystal layer.

16. A semiconductor device, comprising the internally reformed substrate with a multilayer film according to claim 14.

17. A semiconductor device according to claim 16, wherein the semiconductor device serves as any one of a light emitting element, an electronic device, and a light receiving element.

18. A bulk semiconductor substrate, comprising the multilayer film of the internally reformed substrate with a multilayer film according to claim 14.

19. A bulk semiconductor substrate according to claim 18, wherein the bulk semiconductor substrate is made of AlxInyGazN (x+y+z=1, x≥0, y≥0, z≥0).

20. A manufacturing method for an internally reformed substrate for epitaxial growth, comprising forming a heat-denatured layer in an internal portion of a single crystal substrate by laser irradiation to the single crystal substrate.

21. A manufacturing method for an internally reformed substrate for epitaxial growth according to claim 20, wherein the forming comprises performing the laser irradiation so as to satisfy at least one of irradiation conditions A and B described below.
<Irradiation Condition A>
• laser wavelength: 200 nm to 400 nm
• pulse width: order of nanoseconds
<Irradiation Condition B>
• laser wavelength: 400 nm to 5,000 nm
• pulse width: order of femtoseconds to order of picoseconds

22. A manufacturing method for an internally reformed substrate for epitaxial growth according to claim 20 or 21, wherein the forming comprises forming the heat-denatured layer to be positioned, when a relative position of the heat-denatured layer in a thickness direction of the single crystal substrate is assumed to be 0% at one surface serving as a film formation surface and 100% at a surface opposite to the film formation surface, in a range of 3% or more and 95% or less in the thickness direction of the single crystal substrate.

23. A manufacturing method for an internally reformed substrate for epitaxial growth according to any one of claims 20 to 22, wherein the forming comprises forming, in a planar direction of the single crystal substrate, the heat-denatured layer so as to have at least one pattern shape selected from the following shapes:
i) a shape in which a plurality of polygons identical in shape and size are regularly disposed;
ii) a shape in which aplurality of circles or ellipses identical in shape and size are regularly disposed;
iii) a concentric shape;
iv) a shape formed so as to be substantially point-symmetric with respect to a center point of the single crystal substrate;
v) a shape formed so as to be substantially linearly-symmetric with respect to a straight line passing through the center point of the single crystal substrate;
vi) a stripe shape; and
vii) a spiral shape.

24. A manufacturing method for an internally reformed substrate for epitaxial growth according to claim 23, wherein the shape in which the plurality of polygons identical in shape and size are regularly disposed comprises a lattice shape.

25. An internally reformed substrate for epitaxial growth according to claim 24, wherein the forming comprises forming the lattice shape into a pattern in which a pitch between lines constituting the pattern is in a range of 50 µm or more and 2,000 µm or less.

26. A manufacturing method for an internally reformed substrate for epitaxial growth according to any one of claims 20 to 25, wherein the single crystal substrate is made of at least one material selected from sapphire, nitride semiconductor, Si, GaAs, crystal, and SiC.

27. A manufacturing method for an internally reformed substrate for epitaxial growth according to any one of claims 20 to 26,
wherein the single crystal substrate before the heat-denatured layer is formed has a shape in which the film formation surface comprises a concave surface, and
wherein the concave surface has a curvature of more than 0 km⁻¹ and 160 km⁻¹ or less.

28. A manufacturing method for an internally reformed substrate for epitaxial growth according to any one of claims 20 to 26, wherein the concave surface has a curvature of 40 km⁻¹ or more and 150 km⁻¹ or less.

29. A manufacturing method for an internally reformed substrate for epitaxial growth according to any one of claims 20 to 26, wherein the concave surface has a curvature of 85 km⁻¹ or more and 150 km⁻¹ or less.

30. A manufacturing method for an internally reformed substrate for epitaxial growth according to any one of claims 20 to 29, wherein the single crystal substrate has a diameter of 50 mm or more and 300 mm or less.

31. A manufacturing method for an internally reformed substrate for epitaxial growth according to any one of claims 20 to 30, wherein the single crystal substrate has a thickness of 0.05 mm or more and 5.0 mm or less.

32. A manufacturing method for an internally reformed substrate for epitaxial growth according to any one of claims 20 to 31,
wherein the surface serving as the film formation surface of the single crystal substrate comprises a polished surface, and
wherein the forming comprises performing the laser irradiation to the single crystal substrate through the polished surface.

33. A manufacturing method for an internally reformed substrate with a multilayer film, the manufacturing method comprising:
forming a heat-denatured layer in an internal portion of a single crystal substrate by laser irradiation to the single crystal substrate; and
forming a multilayer film comprising two or more layers provided on one surface of the single crystal substrate.

34. A manufacturing method for an internally reformed substrate with a multilayer film according to claim 33, wherein at least one of the two or more layers constituting the multilayer film comprises a nitride semiconductor crystal layer.

35. A manufacturing method for a semiconductor device, comprising forming the semiconductor device with use of the internally reformed substrate with a multilayer film according to claim 14.

36. A manufacturing method for a semiconductor device according to claim 35, wherein the semiconductor device serves as any one of a light emitting element, an electronic device, and a light receiving element.

37. A manufacturing method for a bulk semiconductor substrate, comprising forming the bulk semiconductor substrate with use of the multilayer film of the internally reformed substrate with a multilayer film according to claim 14.

38. A manufacturing method for a bulk semiconductor substrate according to claim 37, wherein the forming comprises forming the bulk semiconductor substrate of AlxInyGazN (x+y+z=1, x≥0, y≥0, z≥0).
